# FASCICULE DE BREVET EUROPEEN

(11) **EP 3 445 141 B1**
(45) Date de publication et mention de la délivrance du brevet: **10.11.2021**
(21) Numéro de dépôt: 18189414.8
(22) Date de dépôt: 16.08.2018
(51) Int. Cl.: H05K 7/14

(54) **FOND DE PANIER À CONTACT ENTRE MODULE ADJACENTS AMÉLIORÉ**
BACKPLANE MIT VERBESSERTEM KONTAKT ZWISCHEN NEBENEINANDER ANGEORDNETEN MODULEN
BACKPLANE HAVING IMPROVED CONTACT BETWEEN ADJACENT MODULES

(30) Priorité: 17.08.2017 FR 1757727
(43) Date de publication de la demande: 20.02.2019
(73) Titulaire: ETABLISSEMENTS GEORGES RENAULT, 44800 Saint Herblain (FR)
(72) Inventeur: THERY, Emmanuel, 44140 LE BIGNON (FR); FRAUD, Gaëtan, 44840 LES SORINIERES (FR)
(74) Mandataire: Vidon Brevets & Stratégie

(56) Documents cités:
- EP-A1- 1 524 890
- EP-A2- 1 587 352
- DE-A1- 19 610 559
- DE-A1-102015 104 290
- US-A1- 2016 286 674

## Description

### 1. Domaine de l'invention

Le domaine de l'invention est celui de la conception et de la fabrication de fonds de panier mis en œuvre en particulier dans l'industrie pour raccorder des équipements électriques comme par exemple des contrôleurs servant à l'alimentation et au pilotage d'outils tels que des visseuses, des perceuses ou autre.

### 2. Art antérieur

Dans l'industrie, par exemple dans celui de la construction aéronautique, de la construction navale, de l'automobile, de l'électroménager ou autre, des outils tels que des visseuses, des perceuses ou autres sont couramment mis en œuvre pour réaliser diverses opérations.

Chaque outil est raccordé à un contrôleur qui en assure l'alimentation électrique et le pilotage.

Les outils sont généralement mobiles individuellement ou portés par des ensembles mobiles alors que les contrôleurs se trouvent déportés et sont fixes.

Les contrôleurs sont généralement raccordés à un fond de panier fixe.

Le fond de panier comprend un bâti, généralement fixé à un mur, portant des modules interconnectés électriquement en eux sur chacun desquels peuvent être connectés électriquement un ou plusieurs contrôleurs.

Le document DE-A1-196 10 559 décrit un fond de panier comprenant un rail de support sur lequel sont montés des modules de bus interconnectés deux-à-deux latéralement au moyen de connecteurs.

Le document DE-A1-10 2015 104290 décrit un autre fond de panier comprenant un rail de support sur lequel sont montés des modules interconnectés latéralement au moyen de contacts.

Les modules assurent l'alimentation électrique des contrôleurs ainsi que la communication entre eux et le réseau du site industriel dans lequel ils se trouvent.

Compte tenu de l'environnement dans lequel ils se trouvent, les contrôleurs, ainsi que les fonds de panier, subissent des vibrations voir des chocs.

Sous l'effet de ces chocs et vibrations, le bâti est susceptible de se déformer occasionnant de micro déplacement relatifs des modules entre eux. Ainsi, les contacts électriques entre les modules interconnectés se déplacent les uns par rapport aux autres et tendent en conséquence :
- à s'user mécaniquement, et
- à s'oxyder du fait que ces déplacements relatifs associés au passage du courant électrique nécessaire au fonctionnement de l'installation induisent la génération de micros arcs électriques ; les contacts électriques chauffent, leur surface s'oxyde, devient moins conductrice selon le phénomène connu sous le nom de charbonnage.

Il résulte en conséquence de ces chocs et vibrations une dégradation progressive des contacts électriques se manifestant par la perte de contact électrique (intermittente ou définitive) entre les modules qui constituent le fond de panier. Cette perte de contact électrique est une défaillance redoutée dans la mesure où elle induit la panne du système de vissage.

Pour éliminer le risque de charbonnage, le principal facteur est l'élimination des micros déplacements relatifs des contacts électriques entre modules.

Plusieurs solutions ont été conçues dans ce dessein.

Une première solution consiste à assurer l'interconnexion électrique entre modules non pas au moyen de contacts mécaniques mais au moyen de liaisons filaires. Dans ce cas, ces liaisons filaires absorbent les déplacements relatifs entre modules sans qu'il y ait des conséquences négatives pour le fonctionnement du système de vissage.

Une deuxième solution consiste à assurer une liaison rigide entre les connecteurs. Pour cela, les connecteurs sont placés dans des enveloppes rigides, fixées les unes par rapport aux autres ou par rapport à une référence commune réputée indéformable, qui garantissent la transmission des efforts sans déformations, donc sans déplacement relatif des connecteurs.

Une troisième solution consiste à mettre en œuvre des contacteurs flottants. Dans ce cas, au moins une des deux parties du connecteur s'interconnectant l'une avec l'autre est montée flottante par rapport au module, la liaison électrique entre la partie flottante et son module étant réalisée par des liaisons filaires. Ainsi, les mouvements relatifs entre les modules sont absorbés par ces liaisons filaires et les deux parties du connecteur sont immobiles l'une par rapport à l'autre ceci éliminant le risque de charbonnage.

Ces diverses solutions permettent de limiter la perte de contact électrique intermittente ou définitive entre les modules et ainsi de limiter la perturbation de la production. Elles présentent néanmoins quelques inconvénients.

L'interconnexion entre modules par liaison filaire nécessite la mise en œuvre de câbles de connexion électrique entre les modules, qui augmentent le volume de l'installation et nécessitent des précautions d'installations : passage de câble à prévoir avec rayon de courbure.

La liaison rigide entre module conduit au surdimensionnement mécanique nécessaire pour :
- créer des interfaces rigides : parois épaisses, liaisons boulonnées ou vissées entre les modules. Cela augmente le volume et la masse de l'installation et rend plus difficile sa mise en place ;
- avoir un support rigide dans le cas où les modules ne sont pas fixés les uns par rapport aux autres, mais tous par rapport au même support. Cela augmente également le volume et la masse de l'installation.

La mise en œuvre de connecteurs flottants induit également une augmentation du volume de l'installation.

Ces trois solutions ont un impact sur le volume de l'installation, sa masse et sa facilité d'intégration sur les lignes de production. Elles nécessitent donc d'être améliorées.

Il existe en conséquence un besoin pour éliminer de manière optimale le risque de perte de contact électrique entre modules d'un fond de panier.

### 3. Objectifs de l'invention

L'invention a notamment pour objectif d'apporter une solution efficace à au moins certains de ces différents problèmes.

En particulier, selon au moins un mode de réalisation, un objectif de l'invention est de fournir une technique qui permet de supprimer, ou à tout le moins de limiter fortement, par comparaison aux solutions de l'art antérieur, le risque de perte de contact électrique entre modules.

Notamment, l'invention a pour objectif, selon au moins un mode de réalisation, de fournir une telle technique qui permet d'éviter le déplacement relatif des contacts entre modules sous l'effet des chocs et vibrations auxquels ils peuvent être soumis.

Un autre objectif de l'invention est, selon au moins un mode de réalisation, de fournir une telle technique qui permet d'éviter les déplacements relatifs entre modules sans impacter de manière significative la masse et/ou le volume de l'installation.

Un autre objectif de l'invention est, selon au moins un mode de réalisation, de fournir une telle technique qui soit simple à mettre en œuvre et/ou économique et/ou fiable.

### 4. Présentation de l'invention

Pour ceci, l'invention propose un fond de panier destiné à recevoir des contrôleurs d'outils, ledit fond de panier comprenant :
- un bâti comprenant au moins deux poutres essentiellement parallèles et distantes, possédant chacune une fibre neutre et une épaisseur mesurée suivant une direction perpendiculaire au plan passant par lesdites fibres neutres,
- au moins deux modules de branchement de contrôleurs d'outils, lesdits modules étant interconnectés électriquement deux-à-deux au moyen de connecteurs électriques s'étendant entre lesdites poutres,
- des moyens de solidarisation desdits modules auxdites poutres,
caractérisé en ce que lesdits modules sont configurés pour que la distance entre le plan médian passant par chacun desdits connecteurs et le plan passant par les fibres neutres desdites poutres est inférieure à 30% de l'épaisseur desdites poutres.

Ainsi, l'invention consiste à placer les contacts électriques entre modules adjacents de manière telle que leurs axes médians respectifs, qui s'étendent entre les poutres, se trouvent dans un plan situé à proximité d'un plan passant par la fibre neutre de chacune des poutres, ces plans étant en l'occurrence éloignés l'un de l'autre sur une distance inférieur à 30% de l'épaisseur des poutres.

Les connecteurs sont ainsi placés dans une zone du châssis ne subissant pas d'allongement ou de rétrécissement lorsque le châssis se déforme sous l'effet des vibrations et chocs auxquels il peut être soumis. Ces vibrations et chocs n'induisent en conséquence pas de déplacement relatif des connecteurs.

L'invention permet alors d'éviter l'usure mécanique des contacts électriques entre modules ainsi que le phénomène de charbonnage. Elle permet en conséquence de limiter de manière significative le risque de perte de contact électrique entre modules et ainsi d'éviter que la production soit perturbée ou interrompue pour cette raison.

Selon une caractéristique possible, chacun desdits modules comprend entre deux et cinq fiches de branchement respectivement aptes à coopérer avec un connecteur d'un contrôleur pour raccorder celui-ci au module correspondant.

Il est ainsi possible d'adapter le nombre de fiches de branchement selon le nombre de contrôleur que l'on souhaite raccorder.

Selon une caractéristique possible, lesdits modules comprennent des nombres différents de fiches de raccordement.

Il est ainsi possible, à partir d'une gamme de modules ayant des nombres de fiches de branchement différents, de composer un fond de panier permettant le raccordement du nombre souhaité de contrôleurs. Cette conception modulaire confère au dispositif selon l'invention une grande polyvalence.

Selon une caractéristique possible, chacun des modules comprend deux connecteurs disposés sur deux côtés opposés dudit module, lesdits connecteurs étant respectivement aptes à coopérer avec les connecteurs de modules voisins.

Il est ainsi possible d'interconnecter plusieurs modules consécutifs de manière simple et efficace.

Selon l'invention, chaque module comprend une platine, chaque platine étant solidarisée à deux de ses extrémités opposées auxdites poutres.

Dans ce cas, chaque platine comprend à l'une de ses extrémités une portion en arc de cercle s'étendant le long d'un axe essentiellement parallèle auxdites poutres, lesdits contrôleurs comprenant une portion de forme complémentaire de la portion en arc de cercle formant avec celle-ci une liaison pivot lorsqu'elles coopèrent pour guider le connecteur du contrôleur à coopérer avec la fiche de branchement d'un module.

Il est ainsi possible de connecteur de manière simple et précise un contrôleur à un fond de panier selon l'invention.

Selon une caractéristique possible, chaque platine forme avec le module correspondant un ensemble monobloc.

Selon l'invention, le connecteur de chaque contrôleur, apte à coopérer avec une fiche de branchement d'un module, est monté mobile entre au moins :
- une position d'accostage dans laquelle il s'étend de manière inclinée latéralement par rapport au côté du contrôleur où il se trouve, et
- une position de connexion dans laquelle il s'étend sensiblement parallèlement au côté du contrôleur où il se trouve,
le passage de ladite position d'accostage à ladite position de connexion étant obtenu lors de la mise en coopération du connecteur d'un contrôleur avec la fiche correspondante du module.

Cette mise en œuvre permet de faciliter et de garantir la connexion d'un contrôleur au fond de panier.

Selon une caractéristique possible, l'axe de ladite liaison pivot et l'angle d'inclinaison dudit connecteur en position d'accostage sont déterminés de manière telle que lorsqu'un contrôleur pivote selon ledit axe et son connecteur affleure la fiche correspondante d'un module, ledit connecteur et ladite fiche s'étendent essentiellement parallèlement, le connecteur restant essentiellement parallèle à ladite fiche au cours du déplacement du contrôleur jusqu'à ce que le connecteur se trouve dans sa position de connexion dans laquelle il est complètement emmanché avec ladite fiche.

On facilite ainsi le raccordement sans endommager les connecteurs.

Selon une caractéristique possible, des moyens de rappel élastique agissent sur chacun des connecteurs pour le ramener dans sa position d'accostage.

Les caractéristiques techniques relatives au rapprochement du plan médian passant par chacun des connecteurs, permettant d'interconnecter deux-à-deux les modules, du plan passant par les fibres neutres des poutres d'une part, et les caractéristiques techniques relatives aux connecteurs mobiles d'autre part peuvent être mises en œuvre indépendamment les unes des autres.

### 5. Liste des figures

D'autres caractéristiques et avantages de l'invention apparaîtront à la lecture de la description suivante de modes de réalisation particuliers, donnée à titre de simple exemple illustratif et non limitatif, et des dessins annexés parmi lesquels :
- la figure 1 illustre une vue de face d'un fond de panier selon l'invention ;
- la figure 2 illustre une vue en coupe selon l'axe A-A de la figure 1 ;
- les figures 3 et 4 illustrent des vues de dessus du fond de panier de la figure 1 avec et sans déformation des poutres supérieure et inférieure ;
- les figures 5, 6 et 7 illustrent respectivement des vues en perspective, de côté et de face d'un module d'un fond de panier selon l'invention ;
- la figure 8 illustre une vue en coupe longitudinale d'un contrôleur selon l'invention ;
- les figures 9, 10 et 11 illustrent respectivement une vue en coupe longitudinale, une vue en perspective et une vue de côté d'un contrôleur coopérant avec un module ;
- la figure 12 illustre un plan passant par les fibres neutres de deux poutres.

### 6. Description de modes de réalisation particuliers

### 6.1. Architecture

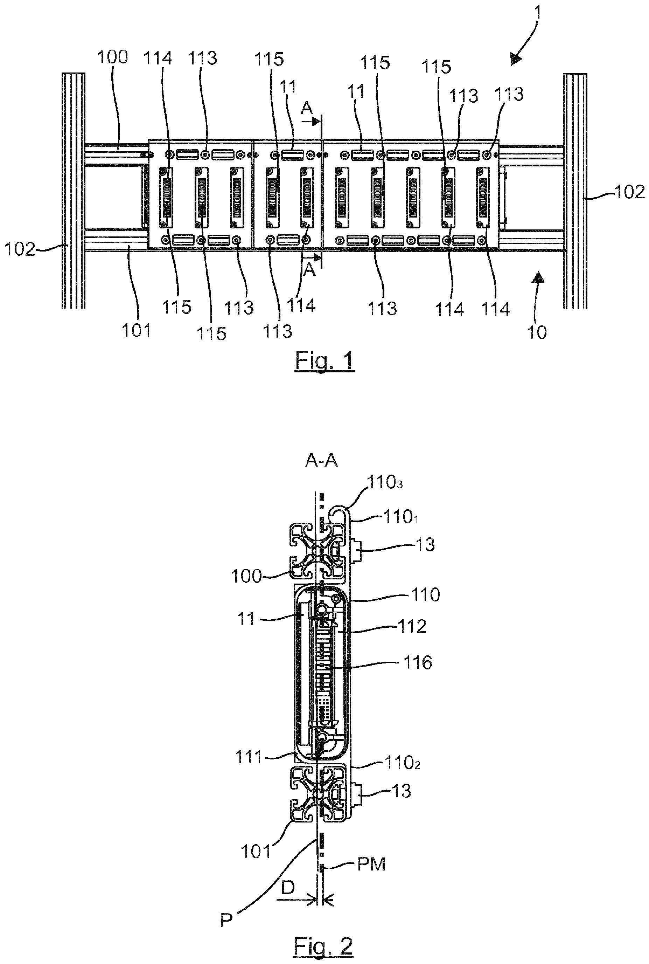

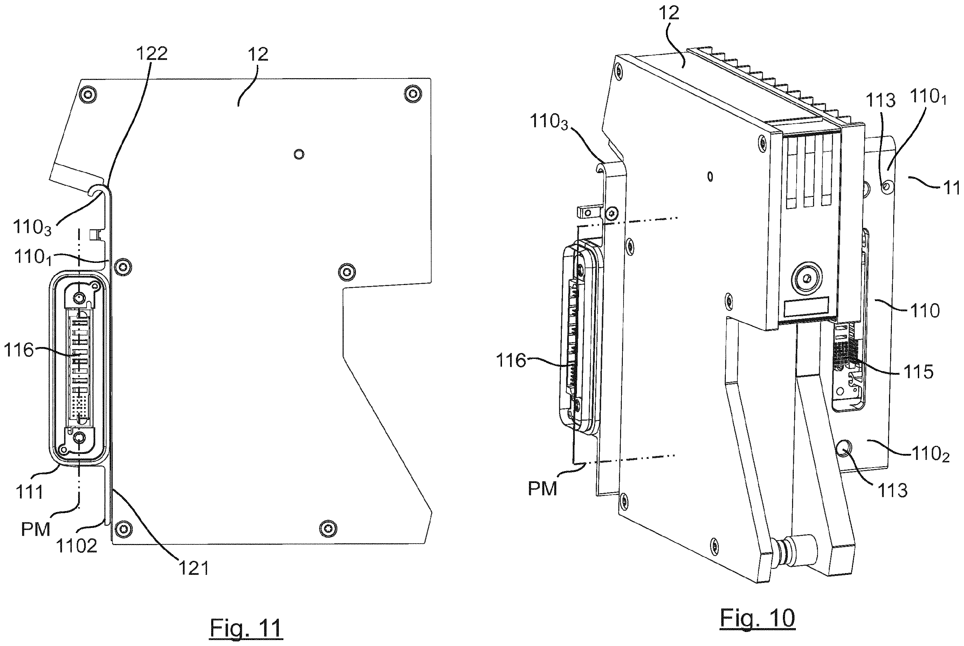

On présente, en relation avec les figures 1 à 12, un exemple de mode de réalisation d'un fond de panier selon l'invention.

Un tel fond de panier 1 comprend un bâti 10. Le bâti 10 comprend une poutre supérieure 100 et une poutre inférieure 101 qui s'étendent sensiblement parallèlement l'une à l'autre et sont distantes l'une de l'autre.

Ces poutres 100, 101 possèdent une fibre neutre FN au sens de la résistance des matériaux, c'est-à-dire une ligne longitudinale passant par le centre de gravité de chaque section transversale au niveau de laquelle elles ne subissent aucun allongement ni aucune compression lorsque les poutres sont soumises à des contraintes de flexion.

Les poutres 100, 101 sont dans cet exemple des poutres du commerce classiquement mises en œuvre pour composer des bâtis industriels. Leur fibre neutre FN s'étend le long de leur axe longitudinal.

Les fibres neutres FN des poutres 100, 101 définissent un plan P qui dans ce mode de réalisation est essentiellement vertical.

Le bâti 10 comprend également deux montants latéraux 102 solidarisés de part et d'autre des poutres 100, 101. Chaque poutre 100, 101 est donc solidarisée à chacune de ses extrémités à un montant latéral 102.

Les montants latéraux 102 s'étendent dans ce mode de réalisation essentiellement perpendiculairement aux poutres 100, 101 et sensiblement verticalement. Ils sont constitués d'éléments classiques du commerce par exemple identiques à ceux mis en œuvre pour réaliser les poutres 100, 101.

Le fond de panier 1 comprend au moins deux modules de branchement 11 d'équipements électriques, en l'occurrence des contrôleurs 12 destinés à être reliés à des outils comme par exemple des visseuses, des perceuses ou autre.

Chaque module de branchement 11 comprend :
- une portion avant formant une platine 110 essentiellement plane, et
- une portion arrière 111 délimitant avec la portion avant 110 un espace intérieur 112.

L'espace intérieur 112 loge les équipements électriques et/ou électroniques composant habituellement un fond de panier. Ceux-ci ne présentent pas de caractère original et ne sont donc pas décrits en détail ici.

La platine 110 s'étend de part et d'autre au-delà de la portion arrière 111 pour former une languette de fixation supérieure 110₁ et une languette de fixation inférieure 110₂.

Les languettes de fixation supérieure 110₁ et inférieure 110₂ sont traversées par des trous 113 qui, comme il sera décrit plus en détail par la suite, permettent de solidariser par vissage le module de branchement 11 aux poutres 100, 101.

La platine 110 est également traversée par des lumières 114 débouchant chacune sur une fiche de branchement 115, située dans l'espace intérieur 112, pour raccorder un contrôleur 12. Dans ce mode de réalisation, les fiches 115 sont frontales.

Le nombre de fiche de branchement 115 par module 11 peut être différent d'un module 11 à l'autre et préférentiellement compris entre deux et cinq. Préférentiellement, des modules 11 possèderont deux, trois ou cinq fiches 115.

L'extrémité supérieure de la languette de fixation 110₁ présente un bord en arc de cercle 110₃ orienté dans ce mode de réalisation vers le côté de la portion arrière 111. Ce bord en arc de cercle 110₃ (ou portion en arc de cercle) s'étend le long d'un axe a essentiellement parallèle aux poutres 100, 101.

Chaque module 11 comprend un connecteur électrique 116 à chacun de ses côtés latéraux. Ces connecteurs 116 sont appelés connecteurs latéraux.

L'un des connecteurs latéraux 116 est mâle, l'autre étant femelle.

Le connecteur latéral 116 mâle d'un module 11 est apte à coopérer avec le connecteur latéral 116 femelle d'un autre module 11.

Les modules 11 peuvent ainsi être interconnectés deux-à-deux électriquement au moyen des connecteurs latéraux 116.

Dans ce mode de réalisation, les connecteurs latéraux 116 s'étendent essentiellement verticalement parallèlement aux platines 110.

Chaque contrôleur 12 comprend un carter 120 logeant les composants électroniques lui permettant classiquement d'assurer ses fonctions. Cette composition électronique ne fait pas l'objet de l'invention et n'est donc pas décrite ici plus en détail.

Le carter 120 comprend une face arrière 121 dans une région supérieure de laquelle est formé un bord en arc de cercle 122. Ce bord 122 s'étend d'un côté à l'autre du carter 120 et présente une forme complémentaire de celle du bord en arc de cercle 110₃ de la platine 110. Les bords en arc de cercle 110₃ et 122 forment, lorsqu'ils coopèrent, une liaison pivot entre le contrôleur 12 et le module 11 correspondants.

Chaque contrôleur 12 comprend un connecteur arrière 123. Chaque connecteur arrière 123 comprend un corps 124 présentant des pattes de fixation inférieure et supérieure 125. Ces pattes de fixation 125 sont traversées chacune par un trou 126. Chaque trou 126 permet le passage d'un axe de fixation 127 comprenant un corps 127₁ et une tête 127₂. Le diamètre des corps 127₁ des axes 127 est inférieur à celui des trous 126 alors que le diamètre de leur tête 127₂ est supérieur à celui des trous 126.

Des moyens de rappel élastique, comme des ressorts de compressions 128, des patins en élastomère ou autre, sont arrangés autour des axes 127 et interposés entre le fond 129 du logement 130 accueillant le connecteur arrière 123 et l'extrémité des pattes de fixation 125 faisant face à ce fond 129.

Le connecteur arrière 123 est ainsi monté flottant et coulissant, contre l'effet des moyens de rappel, le long des axes 127 dans le logement 130.

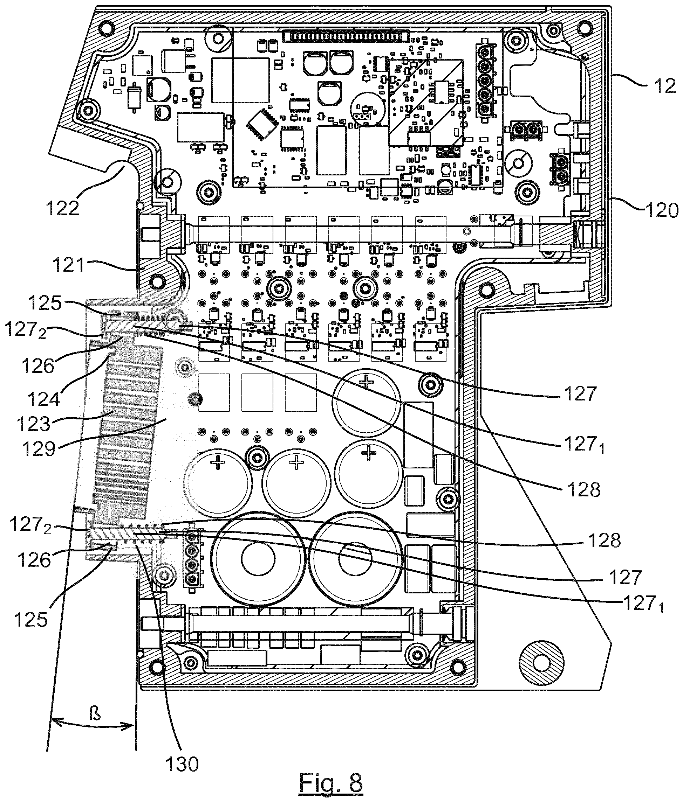

La position des têtes 127₂ permet également de maintenir le connecteur arrière 123 incliné latéralement d'un angle β vers l'arrière dans une position d'équilibre illustrée à la figure 8.

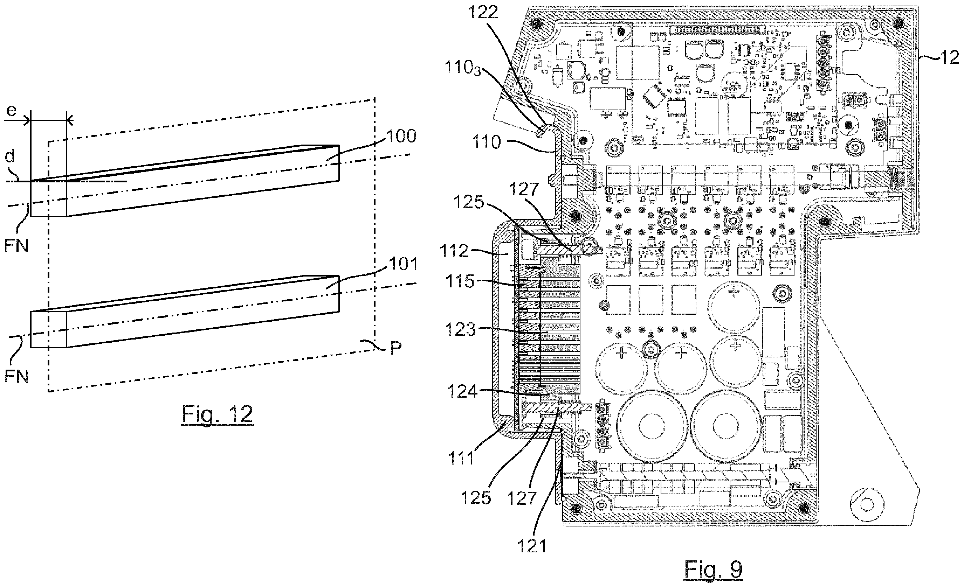

Chaque connecteur arrière 123 est monté mobile entre au moins :
- une position d'accostage, illustrée à la figure 8, dans laquelle il s'étend de manière inclinée latéralement par rapport à la face arrière 121 du contrôleur 12 (il s'agit de la position d'équilibre), et
- une position de connexion, illustrée à la figure 9, dans laquelle il s'étend sensiblement parallèlement à la face arrière 121 du contrôleur 12.

L'axe a de la liaison pivot entre un contrôleur 12 et un module 11, ainsi que l'angle d'inclinaison β du connecteur arrière 123 en position d'accostage sont déterminés de manière telle que lorsqu'un contrôleur 12 pivote selon l'axe a de la liaison pivot et que son connecteur arrière 123 affleure la fiche 115 correspondante d'un module 11, le connecteur arrière 123 et la fiche 115 s'étendent essentiellement parallèlement.

Ensuite, au fur et à mesure que le contrôleur 12 pivote autour de l'axe a de la liaison pivot afin de faire coopérer son connecteur arrière 123 avec la fiche 115 du module 11, le connecteur arrière 123 pivote par rapport au carter 120 du contrôleur 12 en restant parallèle à la fiche 115 du module 11 jusqu'à ce qu'il occupe sa position de connexion dans laquelle il est emmanché dans la fiche 115 et le contrôleur 12 occupe sa position finale dans laquelle sa face arrière 121 est sensiblement parallèle à la platine 110 du module 11.

### 6.2. Solidarisation des modules

La solidarisation de modules 11 au bâti 10 et leur interconnexion est obtenue de la manière suivante.

Pour solidariser un module 11 au bâti 10, la face arrière de sa platine 110, c'est à-dire celle se trouvant du côté de la portion arrière 111, est rapportée contre les faces frontales des poutres supérieure 100 et inférieure 101. La portion arrière 111 ainsi que l'espace 112 se trouvent alors entre les poutres supérieure 100 et inférieure 101.

Le module 11 est ensuite fixé au bâti au moyen de vis 13 passant à travers les trous 113 et vissées dans les poutres 100, 101.

Le module 11 ainsi positionné, ses connecteurs latéraux 116 s'étendent essentiellement verticalement entre les poutres 100, 101.

Un deuxième module 11 est solidarisé au bâti 10 en suivant le même principe. Toutefois, après avoir été plaqué contre les poutres 101, 101 de sorte que son espace intérieur 112 soit situé entre elles, il est déplacé latéralement de sorte que son connecteur latéral 116 coopère avec le connecteur latérale 116 de forme complémentaire du module 11 adjacent.

Autant de modules 11 que nécessaires sont ainsi solidarisés au bâti 10 de manière telle qu'ils soient interconnectés électriquement.

Le connecteur latéral 116 libre d'au moins un des modules 11 d'extrémité pourra être raccordé à une alimentation de puissance et/ou au réseau du site industriel dans lequel est implanté le fond de panier 1.

Les modules 11 sont configurés pour placer le plan médian PM passant par chacun des connecteurs latéraux 116 de chacun des modules 11 de manière telle que ce plan médian PM soit confondu avec le plan P passant par les fibres neutres FN des poutres supérieure 100 et inférieure 101, ou à tout le moins se trouve à proximité de celui-ci. En d'autre terme, ce plan médian PM et le plan P passant par les fibres neutres FN des poutres supérieure 100 et inférieure et 101 sont préférentiellement confondus ou essentiellement parallèles et éloignés l'un de l'autre sur une distance D inférieure à 30% de l'épaisseur e des poutres 100, 101, l'épaisseur e des poutres 100, 101 étant prise selon une direction d essentiellement perpendiculaire au plan P passant par leurs fibres neutres FN. L'épaisseur des poutres 101, 101 pourra par exemple être comprise entre environ 20 et 70 millimètres.

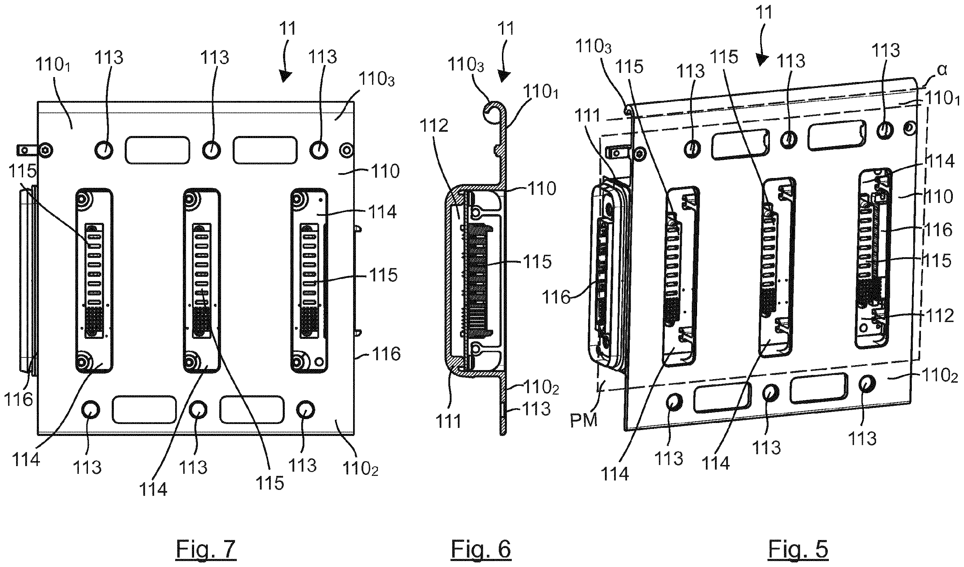

Le plan médian PM des connecteurs latéral 116 est le plan qui passe par le plan milieu longitudinal de chaque connecteur latéral 116, ainsi que cela est représenté sur les figures 5, 10 et 11.

### 6.3. Solidarisation des contrôleurs

La solidarisation d'un contrôleur 12 à un module 11 est obtenue de la manière suivante.

Pour solidariser un contrôleur 12 à un module 11, le bord en arc de cercle 122 du contrôleur 12 est posé sur le bord en arc de cercle 110₃ du module 11 correspondant au droit de la fiche 115 du module 11 à laquelle doit être branché le connecteur arrière 123 du contrôleur 12, l'extrémité inférieure du contrôleur 12 étant inclinée vers le haut. Le connecteur arrière 123 se trouve dans sa position inclinée d'accostage.

Le contrôleur 12 est ensuite déplacé en rotation vers le bas selon l'axe a de la liaison pivot formée entre lui et le module 11 du fait de la coopération des bords en arc de cercle 122 et 110₃ jusqu'à ce que le connecteur arrière 123 vienne au contact, en d'autre terme, affleure, la fiche 115 du module 11. Le connecteur arrière 123 se trouve toujours dans sa potion d'accostage et s'étend essentiellement parallèlement à la fiche 115. Le mouvement de rotation vers le bas est poursuivi de sorte que le connecteur arrière 123 et la fiche 115 se connectent progressivement (le connecteur 123 est mâle et la fiche 115 femelle, ou inversement). Tout au long de cette connexion progressive, le connecteur arrière 123 se déplace dans son logement 130, sa patte de fixation inférieure 125 coulissant vers l'intérieur du contrôleur 12 le long de l'axe 127 correspondant. Il reste de cette façon essentiellement parallèle à la fiche 115 ce qui facilite la connexion entre le contrôleur 12 et le module 11. Le déplacement en rotation vers le bas du contrôleur 12 se poursuit jusqu'à ce que la fiche 115 et le connecteur arrière 123 soient entièrement emmanchés et que la face arrière 121 du contrôleur 12 soit essentiellement parallèle à la platine 110 du module 11.

### 6.4. Avantages

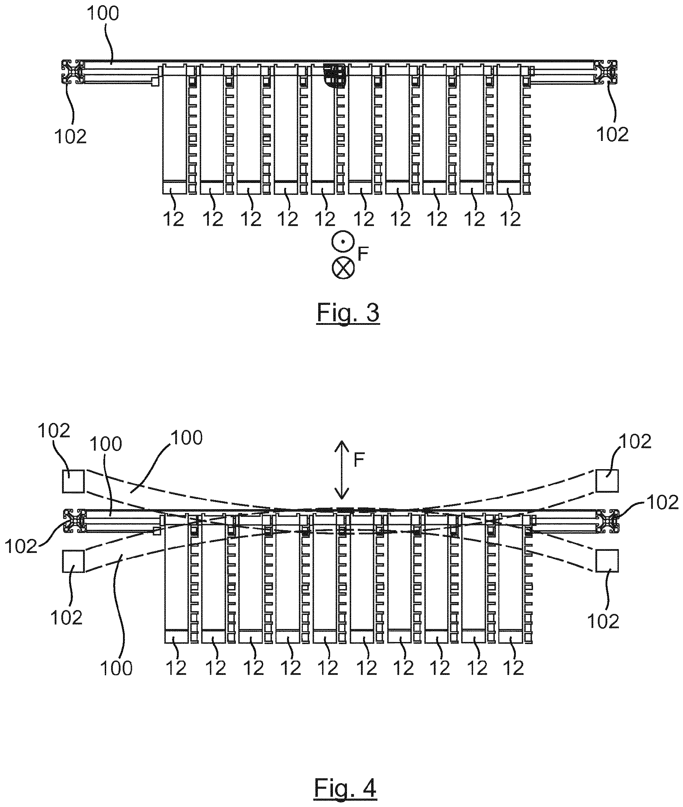

Ainsi que cela est représenté à la figure 4, du fait des chocs et/ou vibrations auxquels le fond de panier 1 peut être soumis en raison de son implantation dans un environnement industriel, les poutres supérieure 100 et inférieure 101 peuvent se déformer essentiellement selon des directions normales au plan P passant par leurs fibres neutres FN (ces directions sont matérialisées par la flèche F).

Sur cette figure 4, les déformées sont représentées de manière illustratives dans des proportions volontairement démultipliées pour améliorer la compréhension.

Dans la mesure où les modules 11 sont configurés pour placer le plan médian PM passant par chacun des connecteurs latéraux 116 de chacun des modules 11 de manière telle que ce plan médian PM soit confondu avec le plan P passant par les fibres neutres FN des poutres supérieure 100 et inférieure 101, ou se trouve à tout le moins à proximité de celui-ci (ce plan médian PM et le plan P passant par les fibres neutres FN des poutres supérieure 100 et inférieure et 101 sont confondus ou essentiellement parallèles et éloignés l'un de l'autre sur une distance D inférieure à 30% de l'épaisseur des poutres 100, 101) on évite aux connecteurs latéraux 116 interconnectés de subir des micro mouvements de déconnexion.

Ainsi, l'invention permet d'éviter l'usure mécanique des connecteurs 116 ainsi que le charbonnage.

La technique selon l'invention permet ainsi de lutter efficacement contre les coupures électriques, temporaires ou permanentes, entre modules 11 interconnectés. Elle concourt ainsi à améliorer la productivité et à éviter que la production soit stoppée en raison de disfonctionnements des contacts électriques entre modules 11.

## Revendications

1. Fond de panier (1) destiné à recevoir des contrôleurs (12) d'outils, ledit fond de panier (1) comprenant :
- un bâti (10) comprenant au moins deux poutres (100, 101) essentiellement parallèles et distantes, possédant chacune une fibre neutre (FN) et une épaisseur (e) mesurée suivant une direction (d) perpendiculaire au plan (P) passant par lesdites fibres neutres (FN),
- au moins deux modules de branchement (11) de contrôleurs (12) d'outils, lesdits modules (11) étant interconnectés électriquement deux-à-deux au moyen de connecteurs électriques (116) s'étendant entre lesdites poutres (100, 101),
- des moyens de solidarisation desdits modules (11) auxdites poutres (100, 101), **caractérisé en ce que** lesdits modules (11) sont configurés pour que la distance (D) entre le plan médian (PM) passant par chacun desdits connecteurs (116) et le plan (P) passant par les fibres neutres (FN) desdites poutres (100, 101) est inférieure à 30% de l'épaisseur (e) desdites poutres (100, 101),
chaque module (11) comprenant une platine (110), chaque platine (110) étant solidarisée à deux de ses extrémités opposées auxdites poutres (100, 101),
chaque platine (110) comprenant à l'une de ses extrémités une portion en arc de cercle (110₃) s'étendant le long d'un axe (α) essentiellement parallèle auxdites poutres (100, 101), lesdits contrôleurs (12) comprenant une portion (122) de forme complémentaire de la portion en arc de cercle (110₃) formant avec celle-ci une liaison pivot lorsqu'elles coopèrent pour guider le connecteur (123) du contrôleur (12) à coopérer avec la fiche de branchement (115) d'un module (11),
le connecteur (123) de chaque contrôleur (12), apte à coopérer avec une fiche de branchement (115) d'un module (11), étant monté mobile entre au moins :
- une position d'accostage dans laquelle il s'étend de manière inclinée latéralement par rapport au côté du contrôleur (12) où il se trouve, et
- une position de connexion dans laquelle il s'étend sensiblement parallèlement au côté du contrôleur (12) où il se trouve,
le passage de ladite position d'accostage à ladite position de connexion étant obtenu lors de la mise en coopération du connecteur (123) d'un contrôleur (12) avec la fiche (115) correspondante du module (11).

2. Fond de panier (1) selon la revendication 1 dans lequel chacun desdits modules (11) comprend entre deux et cinq fiches de branchement (115) respectivement aptes à coopérer avec un connecteur (123) d'un contrôleur (12) pour raccorder celui-ci au module (11) correspondant.

3. Fond de panier (1) selon la revendication 2 dans lequel lesdits modules (11) comprenant des nombres différents de fiches de raccordement (115).

4. Fond de panier (1) selon l'une quelconque des revendications 1 à 3 dans lequel chacun des modules (11) comprend deux connecteurs (116) disposés sur deux côtés opposés dudit module (11), lesdits connecteurs (116) étant respectivement aptes à coopérer avec les connecteurs (116) de modules (11) voisins.

5. Fond de panier (1) selon l'une quelconque des revendications 1 à 4 dans lequel chaque platine (110) forme avec le module (11) correspondant un ensemble monobloc.

6. Fond de panier (1) selon l'une quelconque des revendications 1 à 5 dans lequel l'axe (α) de ladite liaison pivot et l'angle d'inclinaison (β) dudit connecteur (123) en position d'accostage sont déterminés de manière telle que lorsqu'un contrôleur (12) pivote selon ledit axe (α) et son connecteur (123) affleure la fiche (115) correspondante d'un module (11), ledit connecteur (123) et ladite fiche (115) s'étendent essentiellement parallèlement, le connecteur (123) restant essentiellement parallèle à ladite fiche (115) au cours du déplacement du contrôleur (12) jusqu'à ce que le connecteur (123) se trouve dans sa position de connexion dans laquelle il est complètement emmanché avec ladite fiche (115).

7. Fond de panier (1) selon l'une quelconque des revendications 1 à 6 dans lequel des moyens de rappel élastique (128) agissent sur chacun des connecteurs (123) pour le ramener dans sa position d'accostage.

## Patentansprüche

1. Rückwand (1) zur Aufnahme von Werkzeugsteuerungen (12), wobei die Rückwand (1) Folgendes umfasst:
- einen Rahmen (10), der zumindest zwei im Wesentlichen parallele und beabstandete Träger (100, 101) umfasst, die jeweils eine neutrale Faser (FN) und eine Dicke (e), die in einer Richtung (d) senkrecht zu der durch die neutralen Fasern (FN) verlaufende Ebene (P) gemessen wird, aufweisen,
- zumindest zwei Module (11) zum Anschließen von Werkzeugsteuerungen (12), wobei die Module (11) mittels elektrischer Verbinder (116), die sich zwischen den Trägern (100, 101) erstrecken, paarweise elektrisch miteinander verbunden sind,
- Mittel zum Befestigen der Module (11) an den Trägern (100, 101),
**dadurch gekennzeichnet, dass** die Module (11) so konfiguriert sind, dass der Abstand (D) zwischen der Mittelebene (PM), die durch jeden der Verbinder (116) verläuft, und der Ebene (P), die durch die neutralen Fasern (FN) der Träger (100, 101) verläuft, kleiner als 30 % der Dicke (e) der Träger (100, 101) ist,
wobei jedes Modul (11) eine Platte (110) umfasst, wobei jede Platte (110) an zwei ihrer gegenüberliegenden Enden fest mit den Trägern (100, 101) verbunden ist,
wobei jede Platte (110) an einem ihrer Enden einen kreisbogenförmigen Abschnitt (110₃) umfasst, der sich entlang einer zu den Trägern (100, 101) im Wesentlichen parallelen Achse (α) erstreckt, wobei die Werkzeugsteuerungen (12) einen Abschnitt (122) mit einer zum kreisbogenförmigen Abschnitt (110₃) komplementären Form umfassen, der mit diesem eine Schwenkverbindung bildet, wenn sie zusammenwirken, um den Verbinder (123) der Werkzeugsteuerungen (12) so zu führen, dass er mit dem Anschlussstecker (115) eines Moduls (11) zusammenwirkt,
wobei der Verbinder (123) jeder Werkzeugsteuerungen (12), der mit einem Anschlussstecker (115) eines Moduls (11) zusammenwirken kann, beweglich montiert ist zwischen zumindest:
- einer Dockstellung, in der er sich relativ zu der Seite der Werkzeugsteuerungen (12), auf der er sich befindet, in geneigter Weise erstreckt, und
- einer Verbindungsstellung, in der er sich zu der Seite der Werkzeugsteuerungen (12), auf der er sich befindet, im Wesentlichen parallel erstreckt;
wobei der Übergang von der Dockstellung in die Verbindungsstellung beim Zusammensetzen des Verbinders (123) einer Werkzeugsteuerungen (12) mit dem entsprechenden Anschlussstecker (115) des Moduls (11) erreicht wird.

2. Rückwand (1) nach Anspruch 1, wobei jedes der Module (11) zwischen zwei und fünf Anschlusssteckern (115) umfasst, die jeweils mit einem Verbinder (123) einer Werkzeugsteuerungen (12) zusammenwirken können, um diesen mit dem entsprechenden Modul (11) zu verbinden.

3. Rückwand (1) nach Anspruch 2, wobei die Module (11) unterschiedliche Anzahlen an Anschlusssteckern (115) umfassen.

4. Rückwand (1) nach einem der Ansprüche 1 bis 3, wobei jedes der Module (11) zwei Verbinder (116) umfasst, die auf zwei gegenüberliegenden Seiten des Moduls (11) angeordnet sind, wobei die Verbinder (116) jeweils mit den Verbindern (116) benachbarter Module (11) zusammenwirken können.

5. Rückwand (1) nach einem der Ansprüche 1 bis 4, wobei jede Platte (110) mit dem entsprechenden Modul (11) eine einteilige Baugruppe bildet.

6. Rückwand (1) nach einem der Ansprüche 1 bis 5, wobei die Achse (α) der Schwenkverbindung und der Neigungswinkel (β) des Verbinders (123) in der Dockstellung so bestimmt sind, dass sich, wenn sich eine Werkzeugsteuerungen (12) entlang der Achse (α) dreht und ihr Verbinder (123) mit dem entsprechenden Anschlussstecker (115) eines Moduls (11) bündig ist, der Verbinder (123) und der Anschlussstecker (115) im Wesentlichen parallel zueinander erstrecken, wobei der Verbinder (123) während der Bewegung der Werkzeugsteuerungen (12) im Wesentlichen parallel zum Anschlussstecker (115) bleibt, bis sich der Verbinder (123) in seiner Verbindungsstellung befindet, in der er vollständig mit dem Anschlussstecker (115) zusammengesetzt ist.

7. Rückwand (1) nach einem der Ansprüche 1 bis 6, wobei auf jeden der Verbinder (123) elastische Rückholmittel (128) einwirken, um ihn in seine Dockstellung zurückzuholen.

## Claims

1. A backplane (1) intended to receive tool controllers (12), said backplane (1) comprising:
- a frame (10) comprising at least two essentially parallel and distant beams (100, 101), each having a neutral fibre (FN) and a thickness (e) measured in a direction (d) perpendicular to the plane (P) passing through said neutral fibres (FN),
- at least two modules (11) for connecting tool controllers (12), said modules (11) being electrically interconnected in pairs by means of electrical connectors (116) extending between said beams (100, 101),
- means for securing said modules (11) to said beams (100, 101),
**characterised in that** said modules (11) are configured so that the distance (D) between the median plane (PM) passing through each of said connectors (116) and the plane (P) passing through the neutral fibres (FN) of said beams (100, 101) is less than 30% of the thickness (e) of said beams (100, 101),
each module (11) comprising a plate (110), each plate (110) being secured at two opposite ends thereof to said beams (100, 101),
each plate (110) comprising at one end thereof a circular arc portion (110₃) extending along an axis (α) essentially parallel to said beams (100, 101), said controllers (12) comprising a portion (122) of complementary shape to the circular arc portion (110₃) forming therewith a pivot link when they cooperate to guide the connector (123) of the controller (12) to cooperate with the connection plug (115) of a module (11),
the connector (123) of each controller (12), capable of cooperating with a connection plug (115) of a module (11), being movably mounted between at least:
- one docking position in which it extends in a laterally inclined manner relative to the side of the controller (12) where it is located, and
- a connection position in which it extends substantially parallel to the side of the controller (12) where it is located,
the passage from said docking position to said connection position being obtained when the connector (123) of a controller (12) is put in cooperation with the corresponding plug (115) of the module (11).

2. The backplane (1) according to claim 1 wherein each of said modules (11) comprises between two and five connection plugs (115) respectively capable of cooperating with a connector (123) of a controller (12) to couple it to the corresponding module (11).

3. The backplane (1) according to claim 2 wherein said modules (11) comprising different numbers of connection plugs (115).

4. The backplane (1) according to any one of claims 1 to 3 wherein each of the modules (11) comprises two connectors (116) disposed on two opposite sides of said module (11), said connectors (116) being respectively capable of cooperating with the connectors (116) of neighboring modules (11).

5. The backplane (1) according to any one of claims 1 to 4 wherein each plate (110) forms with the corresponding module (11) a one-piece assembly.

6. The backplane (1) according to any one of claims 1 to 5 wherein the axis (α) of said pivot link and the angle of inclination (β) of said connector (123) in the docking position are determined in such a manner that when a controller (12) pivots about said axis (α) and the connector (123) thereof is flush with the corresponding plug (115) of a module (11), said connector (123) and said plug (115) extend essentially parallel, the connector (123) remaining essentially parallel to said plug (115) during the displacement of the controller (12) until the connector (123) is in the connection position thereof in which it is fully engaged with said plug (115).

7. The backplane (1) according to any one of claims 1 to 6 wherein elastic return means (128) act on each of the connectors (123) to return it to the docking position thereof.
